# EUROPÄISCHE PATENTANMELDUNG

(11) **EP 1 439 743 A2**
(43) Veröffentlichungstag der Anmeldung: **21.07.2004**
(21) Anmeldenummer: 04000569.6
(22) Anmeldetag: 14.01.2004
(51) Int. Cl.: H05K 3/02, H05K 3/04

(54) **Verfahren zum Aufbringen von Leiterbahnen auf die Oberfläche von Kunstoff-Formteilen und die erhaltenen Formteile**

(30) Priorität: 17.01.2003 DE 10301516
(71) Anmelder: Ticona GmbH, 65451 Kelsterbach (DE)
(72) Erfinder: Reil, Frank, 65342 Seeheim (DE); Diel, Stefan, 55296 Lörzweiler (DE)

(57) **Zusammenfassung**

Beschrieben wird ein Verfahren, bei dem Oberflächen von geschäumten Kunststoffen unter Zuhilfenahme von selektiv abtragenden Bearbeitungsverfahren mit elektrischen Leiterbahnen versehen werden.

Das Verfahren gestattet die kostengünstige Herstellung von Formteilen aus Kunststoff mit auf der Oberfläche integrierten Leiterbahnen.

Die Verfahrensprodukte lassen sich beispielsweise in der Elektro- und Elektronikindustrie einsetzen.

## Beschreibung

Die vorliegende Erfindung betrifft ein Verfahren, bei dem Oberflächen von Kunststoffen unter Zuhilfenahme von selektiv abtragenden Bearbeitungsverfahren mit elektrischen Leiterbahnen versehen werden.

Formteile aus Kunststoff mit integrierten elektrisch leitenden Schichten oder Bahnen sind beispielsweise aus der Elektro- und Elektronikindustrie hinlänglich bekannt.

Um elektrische Aggregate tragende Bauteile, die zum Beispiel im Kraftfahrzeugbereich oder Haushaltsmaschinen verwendet werden, mit Elektrizität zu versorgen, werden bislang oft aufwendige Kabelbäume benutzt.

Eine andere Möglichkeit besteht darin, Leiterbahnen durch Heißprägen auf die Kunststoffoberfläche zu bringen. Hierbei werden Metallfolien aus zum Beispiel Kupfer, Gold oder Nickel mit Dicken von in der Regel 18-150 µm mit einem beheizten Stempelklischee auf das Kunststoffsubstrat geprägt.

Eine weitere Gruppe von Verfahren betrifft den Einsatz metallisierbarer Kunststoffe, die in mehrstufigen Verfahren so angeordnet werden, dass durch partielles Metallisieren Leiterbahnen entstehen.

Die bisher bekannten Verfahren zur Herstellung von Formteilen aus Kunststoff mit integrierten Leiterbahnen sind sehr kostenintensiv und apparativ aufwendig, so dass alternative Möglichkeiten gesucht werden.

Es ist allgemein bekannt, dass Kunststoffe durch Zugabe von elektrisch leitfähigen Partikeln elektrisch leitfähig gemacht werden können. Das Ausmass der elektrischen Leitfähigkeit kann beeinflusst werden durch Art der Füllstoffe, deren Größe, Form, Verteilung und Menge.

Es ist auch bekannt, dass die Abhängigkeit der elektrischen Leitfähigkeit eines Kunststoffes von der Menge der eingesetzten Partikel die Form einer sogenannten Perkolationskurve aufweist. Danach verhält sich der Kunststoff bei niedrigen Füllstoffgehalten als elektrischer Isolator. Ab einer bestimmten Menge an Füllstoff steigt die elektrischen Leitfähigkeit sprunghaft an, da sich in dem Formteil Brücken an leitfähigem Material ausbilden.

Die Herstellung von Schaumkunststoffen mit geschäumtem Kern und fester Außenhaut ist ebenso bekannt. Derartige Schäume werden als Integral- oder Strukturschaumstoffe bezeichnet (vergl. Römpp, Lexikon Chemie, Stichwort "Schaumkunststoffe", S. 3952, G. Thieme Verlag, Stuttgart, New York, 1997). Diese Schaumstoffe zeichnen sich durch eine ausgesprochen inhomogene Verteilung von Eigenschaften, wie Dichte, innerhalb der Struktur aus (vergl. J.L. Throne in Journal of Cellular Plastics, July/August 1972, p. 208-210, und Encyclopedia of Polymer Science and Engineering, Vol. 15, "Structural Foams", p. 771-773, John Wiley & sons, 1985).

Ausgehend von diesem Stand der Technik wird mit der Erfindung ein Verfahren bereitgestellt, mit dem Oberflächen von Kunststoffen mit elektrischen Leiterbahnen versehen werden können und dass einfach und wirtschaftlich durchführbar ist.

Die Erfindung beruht auf der Erkenntnis, dass die elektrisch leitfähige Oberfläche von Strukturschaumstoffen, welche einen elektrisch isolierenden Kern aufweisen, gezielt verändert werden kann, so dass an diesen Stellen elektrisch nicht leitende Teile der Oberfläche erzeugt werden und sich dadurch Leiterbahnen ausbilden lassen.

Die vorliegende Erfindung betrifft ein Verfahren zum Verfahren zum Aufbringen von Leiterbahnen auf die Oberfläche eines Kunststoff-Formteils umfassend die Schritte:
a) Vorlage eines Formteils mit mindestens einer Kunststoffoberfläche, wobei das Formteil einen Strukturschaumstoff mit fester Außenhaut und zelligem Kern aufweist und elektrisch leitfähige Partikel in einer solchen Menge enthält, dass der Kern elektrisch isolierend und die Außenhaut elektrisch leitfähig ist, und
b) Abtragen derjenigen Teile der Kunststoffoberfläche, an denen keine Leiterbahnen verlaufen sollen, mit Hilfe eines selektiv abtragenden Bearbeitungsverfahrens, so dass sich an den behandelten Stellen der Kunststoffoberfläche ein vorbestimmtes Muster elektrisch nicht leitender Anteile ausbildet und dadurch an den unbehandelten Stellen der Oberfläche Leiterbahnen entstehen.

Für das erfindungsgemäße Verfahren können beliebige selektiv abtragende Bearbeitungsverfahren, wie mechanische, chemische oder thermische Verfahren zum Einsatz kommen, mit denen vorbestimmte Anteile der Oberfläche des Formteils abgetragen werden können, so dass der darunter liegende elektrisch nicht leitende Schaum freigelegt wird. Beispiele für selektiv abtragende Bearbeitungsverfahren sind mechanische Abtragsverfahren, wie Fräsen, Hobeln, Stanzen oder Strahlverfahren, wie Wasserstrahl- oder Sandstrahlverfahren, elektro-mechanische Abtragsverfahren, wie Funkenerosion, oder insbesondere die Behandlung der Oberfläche mit elektromagnetischer Strahlung, die von der Oberfläche absorbiert wird.

Beispiele für elektromagnetische Strahlung sind Röngtenstrahlung oder vorzugsweise Infrarotstrahlung, sichtbares Licht oder UV-Strahlung.

Besonders bevorzugt wird Laserstrahlung, da diese eine hohe Energiedichte aufweisen kann. Beispiele für Laser sind Excimer-Laser, YAG-Laser oder CO₂-Laser

Unter "elektrisch isolierend" sind im Rahmen dieser Beschreibung spezifische Durchgangswiderstände von größer als 10⁶ Ohm*cm und/oder spezifische Oberflächenwiderstände von größer als 10⁷ Ohm anzusehen.

Unter "elektrisch leitfähig" sind im Rahmen dieser Beschreibung spezifische Durchgangswiderstände von kleiner als 10⁶ Ohm*cm und/oder spezifische Oberflächenwiderstände von kleiner als 10⁷ Ohm anzusehen.

Der erfindungsgemäß zum Einsatz kommende Strukturschaumstoff weist eine feste Außenhaut und einen zelligen Kern auf, die beide elektrisch leitfähige Partikel aufweisen. Dabei ist die Menge der elektrisch leitfähigen Partikel so zu wählen, dass der Kern elektrisch isolierend und die Außenhaut elektrisch leitfähig ist. In der Regel wird sich die auf den Kunststoff bezogene Menge an elektrisch leitfähigen Partikeln in Kern und Außenhaut nicht oder nicht wesentlich unterscheiden. Der Unterschied in der elektrischen Leitfähigkeit beider Teile des Formteils resultiert hauptsächlich aus der Porenstruktur des Kerns und der geschlossenen Struktur der Außenhaut.

Typischerweise besitzt die feste Außenhaut eine Dicke von 50 bis 1.000 µm, vorzugsweise von 100 bis 400 µm und der zellige Kern weist eine Dicke von 200 bis 10.000 µm, vorzugsweise von 1.000 bis 4.000 µm auf.

Der erfindungsgemäß eingesetzte Strukturschaumstoff mit fester Außenhaut und zelligem Kern kann auf beliebige Arten hergestellt werden. So ist die Herstellung durch chemisches Schäumen, d.h. durch Zerfall eines Treibmittels entsteht ein Gas, das wiederum den Kunststoff aufschäumt, oder durch physikalisches Schäumen, d.h. es wird ein inertes Gas unter hohem Druck in die zu schäumende Kunststoffschmelze als Treibmittel injiziert.

Vorzugsweise erfolgt die Ausbildung des Strukturschaumstoffes durch Schaumspritzgussverfahren.

Der zellige Kern des erfindungsgemäß eingesetzten Strukturschaumstoffe kann beliebige Arten, Größen und Anzahlen von Zellen aufweisen. So sind neben offenzelligen Schäumen (= Zellen sind miteinander verbunden) auch geschlossenzellige Schäume (= keine Verbindung der Zellen untereinander) möglich. Selbstverständlich sind auch gemischtzellige Schäume, also Schäume mit offenen und geschlossenen Zellen, möglich.

In der Außenhaut der erfindungsgemäß eingesetzten Strukturschaumstoffe sind zumindest die Anzahl der auftretenden Zellen gegenüber dem zelligen Kern deutlich reduziert. Die Zahl der Zellen darf dabei eine bestimmte Größenordnung nicht überschreiten, so dass die elektrische Leitfähigkeit der Außenhaut der ins Auge gefassten Anwendung genügt.

Die Grösse der Zellen in den erfindungsgemäß eingesetzten Strukturschaumstoffen in den kann sich im Bereich von 0,1 bis 500 µm bewegen.

Die Anzahl der Zellen pro cm³ Schaumstoff kann sich beim zelligen Kern im Bereich von 10⁵ bis 10¹² bewegen. Dabei handelt es sich um typische Werte die im Einzelfall noch über- bzw. unterschritten werden können.

Typische innere Oberflächen (gemessen nach dem B.E.T. Verfahren) der zelligen Kerne der erfindungsgemäß eingesetzten Strukturschäume bewegen sich im Bereich von 0,1 - 400 m²/g.

Vorzugsweise werden Strukturschäume eingesetzt, deren zelliger Kern ein mikrozellulärer Schaum ist. Dabei handelt es sich um Schäume mit Zellen einer Größe im Bereich von 1 bis 20, vorzugsweise 1 bis 10 µm. Besonders bevorzugt handelt es sich um geschlossenzellige mikrozelluläre Schäume mit einer porenfreien oder nahezu porenfreien Randzone.

Die erfindungsgemäß eingesetzten elektrisch leitfähigen Partikel können aus beliebigen Materialen ausgewählt werden. Beispiele dafür sind Metalle oder Metalllegierungen, Russ, Graphit und/oder elektrisch leitfähige Kunststoffe. Vorzugsweise verwendet man ein gut elektrisch leitfähiges Metall.

Die Partikel können in unterschiedlichsten Ausgestaltungen und Materialkombinationen zum Einsatz kommen. Sie werden beispielsweise in Form von Pulvern oder Fasern eingesetzt, wobei die Partikel ihrerseits mit elektrisch leitfähigen Materialien beschichtet sein können.

Beispiele für bevorzugt eingesetzte Partikel sind Leitfähigkeitsruße, Graphitpulver, metallbeschichtete Graphitpulver, z.B. nickel-beschichtetes Graphitpulver, Kohlenstofffasern, Metallfasern, z.B. Fasern aus rostfreiem Stahl, metallbeschichtete Kohlenstofffasern, und Metallpulver.

Durch Auswahl von Art und Menge geeigneter Partikel lassen sich neben der elektrischen Leitfähigkeit auch andere Eigenschaften, wie Schrumpfverhalten (isotrop oder anisotrop), Festigkeit, Bruchdehnung, E-Modul, magnetische Eigenschaften und Abschirmung gegen elektromagnetische Strahlungen, günstig beeinflussen.

Im erfindungsgemäßen Verfahren können Leiterbahnenmuster in unterschiedlichster Ausgestaltung auf der Kunststoffoberfläche erzeugt werden. Die isolierenden Stellen der Oberfläche bilden sich an den selektiv abgetragenen Stellen aus und an den nicht abgetragenen Stellen entstehen die Leiterbahnenmuster.

Die Erfindung betrifft auch die nach dem beschriebenen Verfahren erhältlichen Formteile.

Dabei handelt es sich also um Formteile mit mindestens einer Kunststoffoberfläche, wobei das Formteil einen Strukturschaumstoff mit fester Außenhaut und zelligem Kern aufweist und elektrisch leitfähige Partikel in einer solchen Menge enthält, dass der Kern elektrisch isolierend und die Außenhaut elektrisch leitfähig ist, und wobei vorbestimmte Teile der Außenhaut in Form eines Leiterbahnenmusters vorliegen und die anderen Teile der Außenhaut der Kunststoffoberfläche abgetragen worden sind, so dass sich an diesen Stellen ein vorbestimmtes Muster elektrisch nicht leitender Teile der Kunststoffoberfläche ausgebildet hat.

Leitende Strukturen tragende Formteile können beispielsweise in der Elektround Elektronikindustrie verwendete Bauteile sein, aber auch andere beliebig geformte große oder kleine Kunststoffteile, die an bestimmten Stellen mit leitenden Elementen versehen sind.

Das erfindungsgemäß bearbeitete Formteil kann auch Bestandteil eines Verbundkörpers mit anderen Materialien sein und/oder Bauteile auf der Oberfläche enthalten.

Durch das erfindungsgemäße Verfahren kann bei zahlreichen Bauteilen auf aufwendige Kabelbäume und Kontaktierung mit Steckverbindern verzichtet werden, da die Leiterstrukturen oder Leiterstrukturen tragende Bauteile auf der Oberfläche des Kunststoffformteils angebracht sind. Ebenso können die hohen Kosten und der hohe apparative Aufwand beim Heißprägen von Leiterbahnen oder bei der Herstellung von Leiterbahnen mittels Metallisierung mit dem vorliegenden Verfahren verringert werden.

Das mit Leiterbahnen zu versehende Formteil kann aus einem beliebigen Kunststoff hergestellt sein.

Für das erfindungsgemäße Verfahren können prinzipiell alle schäumbaren Kunststoffe eingesetzt werden.

Wird als Oberflächenbehandlungsverfahren eine Behandlung mit elektromagnetischer Strahlung vorgenommen, so müssen die geschäumten Kunststoffe die zur Strukturierung der Oberfläche vorgesehene elektromagnetische Strahlung in ausreichendem Maße absorbieren. Dieses kann durch den Zusatz von Additiven gefördert werden.

Als Beispiele für Kunststoffe seien hier Polystyrol und Styrol Copolymere, Polyvinylchlorid, Polycarbonate, Polyester, wie flüssig-kristalline Polyester ("LCP") oder Polybutylenterephthalat ("PBT"), oder Polyacetal-Homo- und -Copolymere ("POM"), Polyphenylensulfid, Polyolefine, Polyurethane, Polyisocyanurate, Polycarbodiimid, Polymethacrylimide, Polyamide, Acryl-Butadien-Styrol-Blockcopolymere ("ABS"), Phenol- und Harnstoffharze genannt.

Bevorzugt werden flüssig-kristalline Polyester, Polybutylenterephthalat, Polyacetal-Homo- und -Copolymere sowie Polyphenylensulfid eingesetzt.

Diese Kunststoffe können auch die üblichen Hilfs-, Zusatz-, Füll- und Verstärkungsmittel enthalten, sofern dadurch das für das Strukturieren der Oberfläche erforderliche Eigenschaftsprofil nicht nennenswert beeinträchtigt wird.

Auch homogene und heterogene Kunststoffmischungen können verwendet werden. Bei der Anwendung von elektromagnetischer Strahlung zur Strukturierung der Oberflächen sind je nach Art des verwendeten Kunststoffs die Wellenlänge und die Intensität der Strahlung abzustimmen. Hiervon hängt insbesondere die erforderliche Einstrahldauer und somit die erreichbare Bearbeitungsgeschwindigkeit ab. Transparente Kunststoffe und solche ohne einen nennenswerten Anteil absorbierender Bestandteile können mit Zusätzen, wie zum Beispiel mit Rußen, Füllstoffen oder Pigmenten vermischt sein, die für eine ausreichende Absorption der Strahlung sorgen, sofern die Anwesenheit der elektrisch leitfähigen Partikel nicht bereits für ausreichende Absorption der Strahlung sorgt.

Beispiele für transparente Kunststoffe sind Ethylen-Norbornen-Copolymere, Polystyrol, Polymethylmethacrylat und andere acrylatbasierende Kunststoffe.

Als Strahlungsquellen kommen die an sich üblichen Quellen für elektromagnetische Strahlung zum Einsatz. Beispiele dafür sind Lasertypen, wie Kohlendioxidlaser, YAG (Yttrium-Aluminium-Granat)-Laser oder Excimer-Laser.

Das erfindungsgemäße Verfahren lässt sich in vielen industriellen Bereichen einsetzen. Beispielsweise in der Automobilindustrie zur Herstellung von Ausrüstungsgegenständen, wie Instrumentenclustern, Türschlössern oder Motorsteuerungen; oder in der Elektronikindustrie zur Fertigung von Platinen, beispielsweise für die Herstellung von Telekommunikationseinrichtungen, Computern oder HiFi-Geräten.

Die Erfindung betrifft auch die Verwendung von Strukturschäumen enthaltend elektrisch leitfähige Partikel zur Herstellung von Bauteilen, bei denen auf vorbestimmten Teilen der Oberfläche Leiterbahnen ausgebildet sind.

## Patentansprüche

1. Verfahren zum Aufbringen von Leiterbahnen auf die Oberfläche eines Kunststoff-Formteils umfassend die Schritte:
a) Vorlage eines Formteils mit mindestens einer Kunststoffoberfläche, wobei das Formteil einen Strukturschaumstoff mit fester Außenhaut und zelligem Kern aufweist und elektrisch leitfähige Partikel in einer solchen Menge enthält, dass der Kern elektrisch isolierend und die Außenhaut elektrisch leitfähig ist, und
b) Abtragen derjenigen Teile der Kunststoffoberfläche, an denen keine Leiterbahnen verlaufen sollen, mit Hilfe eines selektiv abtragenden Bearbeitungsverfahrens, so dass sich an den behandelten Stellen der Kunststoffoberfläche ein vorbestimmtes Muster elektrisch nicht leitender Anteile ausbildet und dadurch an den unbehandelten Stellen der Oberfläche Leiterbahnen entstehen.

2. Verfahren nach Anspruch 1, **dadurch gekennzeichnet, dass** das selektiv abtragende Bearbeitungsverfahren ausgewählt wird aus der Gruppe bestehend aus mechanischen Abtragsverfahren, Strahlverfahren, elektromechanischen Abtragsverfahren, oder Behandlung der Oberfläche mit elektromagnetischer Strahlung, die von der Oberfläche absorbiert wird.

3. Verfahren nach Anspruch 2, **dadurch gekennzeichnet, dass** die elektromagnetische Strahlung ausgewählt wird aus der Gruppe bestehend aus Röntgenstrahlung, Infrarotstrahlung, sichtbarem Licht oder UV-Strahlung.

4. Verfahren nach Anspruch 3, **dadurch gekennzeichnet, dass** die elektromagnetische Strahlung Laserstrahlung ist.

5. Verfahren nach Anspruch 1, **dadurch gekennzeichnet, dass** als Formteil ein Strukturschaumstoff mit fester Außenhaut und zelligem Kern eingesetzt wird, dessen feste Außenhaut eine Dicke von 50 bis 1.000 µm, und dessen zelliger Kern eine Dicke von 200 bis 10.000 µm aufweist.

6. Verfahren nach Anspruch 1, **dadurch gekennzeichnet, dass** als Formteil ein Strukturschaumstoff mit fester Außenhaut und zelligem Kern eingesetzt wird, dessen zelliger Kern ein mikrozellulärer Schaum mit Zellen einer Größe im Bereich von 1 bis 20 µm ist.

7. Verfahren nach Anspruch 1, **dadurch gekennzeichnet, dass** der Kern einen spezifischen Durchgangswiderstand von mehr als 10⁷ Ohm * cm und die Außenhaut einen spezifischen Durchgangswiderstand von weniger als 10⁶ Ohm * cm aufweisen.

8. Verfahren nach Anspruch 1, **dadurch gekennzeichnet, dass** die elektrisch leitfähigen Partikel ausgewählt werden aus der Gruppe bestehend aus Leitfähigkeitsrußen, Graphitpulvern, metallbeschichteten Graphitpulvern, Kohlenstofffasern, Metallfasern, metallbeschichteten Kohlenstofffasern, Metallpulvern oder Kombinationen von einem oder mehreren dieser Komponenten.

9. Verfahren nach Anspruch 1, **dadurch gekennzeichnet, dass** der Kunststoff ausgewählt wird aus der Gruppe bestehend aus flüssig-kristallinen Polyestern, Polybutylenterephthalat, Polyacetal-Homo- und -Copolymeren sowie Polyphenylensulfid und Gemischen aus einem oder mehreren davon.

10. Formteile mit mindestens einer Kunststoffoberfläche erhältlich nach dem Verfahren gemäß Anspruch 1, wobei das Formteil einen Strukturschaumstoff mit fester Außenhaut und zelligem Kern aufweist und elektrisch leitfähige Partikel in einer solchen Menge enthält, dass der Kern elektrisch isolierend und die Außenhaut elektrisch leitfähig ist, und wobei vorbestimmte Teile der Außenhaut in Form eines Leiterbahnenmusters vorliegen und die anderen Teile der Außenhaut der Kunststoffoberfläche abgetragen worden sind, so dass sich an diesen Stellen ein vorbestimmtes Muster elektrisch nicht leitender Teile der Kunststoffoberfläche ausgebildet hat.

11. Verwendung von Strukturschäumen enthalten elektrisch leitfähige Partikel zur Herstellung von Bauteilen, bei denen auf vorbestimmten Teilen ihrer Oberfläche Leiterbahnen ausgebildet sind.
